# EUROPEAN PATENT APPLICATION

(11) **EP 2 149 900 A2**
(43) Date of publication of application: **03.02.2010**
(21) Application number: 09166860.8
(22) Date of filing: 30.07.2009
(51) Int. Cl.: H01L 21/58, H01L 21/68, C09J 7/02

(54) **Dicing die-bonding film**

(30) Priority: 01.08.2008 JP 2008199842
(71) Applicant: NITTO DENKO CORPORATION, Ibaraki-shi, Osaka 567-8680 (JP)
(72) Inventor: Matsumura, Takeshi, Ibaraki-shi Osaka 567-8680 (JP); Kamiya, Katsuhiko, Ibaraki-shi Osaka 567-8680 (JP); Murata, Shuuhei, Ibaraki-shi Osaka 567-8680 (JP); Sugo, Yuki, Ibaraki-shi Osaka 567-8680 (JP)
(74) Representative: Sajda, Wolf E.

(57) **Abstract**

The present invention is a dicing die-bonding film having a dicing film having a pressure-sensitive adhesive layer (2) on an ultraviolet-ray transmitting base (1) and a die-bonding film (3) provided on the pressure-sensitive adhesive layer (2), wherein the pressure-sensitive adhesive layer (2) is formed by laminating the die-bonding film (3) onto a pressure-sensitive adhesive layer precursor formed from an acrylic polymer comprising an acrylic ester as a main monomer, a hydroxyl group-containing monomer at a ratio in the range of 10 to 40 mol% with respect to 100 mol% of the acrylic ester, and an isocyanate compound having a radical reactive carbon-carbon double bond within a molecular at a ratio in the range of 70 to 90 mol% with respect to 100 mol% of the hydroxyl group-containing monomer, and then curing by irradiating with an ultraviolet ray from the base side, and the die-bonding film is formed from an epoxy resin.

## Description

### BACKGROUND OF THE INVENTION

### Field of the Invention

The present invention relates to a dicing die-bonding film that is used in dicing of a workpiece under a condition where an adhesive for fixing a chip-shaped workpiece such as a semiconductor chip and an electrode member is pasted onto a workpiece such as a semiconductor wafer before dicing, a manufacturing method thereof, and a method of manufacturing a semiconductor device using it.

### Description of the Related Art

A semiconductor wafer (workpiece) on which a circuit pattern is formed is diced into semiconductor chips (chip-shaped workpieces) (a dicing step) after the thickness thereof is adjusted by backside polishing as necessary. In the dicing step, it is common to wash the semiconductor wafer at an appropriate liquid pressure (normally, about 2 kg/cm²) to remove a cut layer. Next, the semiconductor chips are fixed onto an adherend such as a lead frame with an adhesive (a mounting step), and then they are transferred to a bonding step. In the mounting step, the adhesive is applied onto the lead frame or the semiconductor chip.
However, this method can hardly make an adhesive layer uniform, and a special apparatus and a long time are necessary for the application of the adhesive. Accordingly, a dicing die-bonding film is proposed that provides an adhesive layer for fixing chips that is necessary in the mounting step while adhering and holding a semiconductor wafer in the dicing step (for example, refer to Japanese Patent Application Laid-Open JP-A-60-057 642).

The dicing die-bonding film described in Japanese Patent Application Laid-Open JP-A-60-057 642 provides a peelable adhesive layer onto a support base. That is, the semiconductor wafer is diced while being held by the adhesive layer, the semiconductor chips are peeled off together with the adhesive layer by stretching the support base, and the individual semiconductor chips are collected and fixed onto an adherend such as a lead frame with the adhesive layer in between.

A good holding strength toward the semiconductor wafer and a good peeling property such that the semiconductor chips after dicing and the adhesive layer can be peeled off a support base integrally are desired for an adhesive layer of a dicing die-bonding film of this type so that a dicing impossibility, a dimensional error, or the like does not occur. However, it has never been easy to balance both characteristics. Especially when a large holding strength is required in the adhesive layer such as in a method of dicing a semiconductor wafer with a rotary circular blade, or the like, it is difficult to obtain a dicing die-bonding film that satisfies the above-described characteristics.

Then, in order to overcome such problems, various improved methods have been proposed (for example, refer to Japanese Patent Application Laid-Open JP-A-2-248 064). In this document, a method is proposed that makes picking up of a semiconductor chip easy by providing an ultraviolet-ray curable pressure-sensitive adhesive layer between the support base and the adhesive layer, decreasing the adhering strength between the pressure-sensitive adhesive layer and the adhesive layer by curing the product with an ultraviolet ray after dicing, and peeling the two layers from each other.

However, even with this improved method, there is a case that it is difficult to have a dicing die-bonding film in which the holding strength during dicing and the peeling property after dicing is balanced well. For example, in the case of a large semiconductor chip that is 10 mm x 10 mm or more or a very thin semiconductor chip 25 to 50 µm in thickness, the semiconductor chip cannot be picked up easily with a general die bonder because of the large area.

For such problems, Japanese Patent Application Laid-Open JP -A-2005--5355 discloses that the pickup property is improved by irradiating a portion corresponding to a pasting portion of a semiconductor wafer in a pressure-sensitive adhesive layer and curing the corresponding portion. However, when the dicing die-bonding film described in this document is used, there is a case that the adhesive constituting the die-bonding film overflows onto the cut face after dicing and with this the cut faces reattach to each other (blocking). As a result, there occurs a problem that pickup of a semiconductor chip becomes difficult.

As a semiconductor chip is desired that has been becoming thinner and smaller in recent years. Moreover, when producing a semiconductor chip having a chip size of 1 mm x 1 mm by dicing, a dicing die-bonding film is desired that is capable of preventing occurrence of chip fly.

### SUMMARY OF THE INVENTION

The present invention has been made in view of the above-described problems, and an object thereof is to provide a dicing die-bonding film including a dicing film having a pressure-sensitive adhesive layer on a base and a die-bonding film provided on the pressure-sensitive adhesive layer, and even when the semiconductor wafer is thin, having balanced characteristics of holding strength when dicing the thin semiconductor wafer and peeling property when peeling off the semiconductor chip that is obtained by dicing and its die-bonding film integrally, a manufacturing method thereof, and a method of manufacturing a semiconductor device using it.

The inventors of the present invention investigated a dicing die-bonding film, a manufacturing method thereof, and a method for manufacturing a semiconductor device using dicing die-bonding film to solve the conventional problem points. As a result, they found that occurrence of chip fly is prevented even when producing a semiconductor chip having a very small chip size such as less than 1 mm square and the peeling property can be improved even when picking up a very thin semiconductor chip of 25 to 75 µm thickness when using the dicing die-bonding film having a pressure-sensitive adhesive layer that is cured by ultraviolet ray irradiation after a die-bonding film is laminated thereon, which led to the completion of the present invention,

That is, in order to solve the above-mentioned problems, the present invention relates to a dicing die-bonding film having a dicing film having a pressure-sensitive adhesive layer on an ultraviolet-ray transmitting base and a die-bonding film provided on the pressure-sensitive adhesive layer, wherein the pressure-sensitive adhesive layer is formed by laminating the die-bonding film onto a pressure-sensitive adhesive layer precursor formed from an acrylic polymer comprising an acrylic ester as a main monomer, a hydroxyl group-containing monomer at a ratio in the range of 10 to 40 mol% with respect to 100 mol% of the acrylic ester, and an isocyanate compound having a radical reactive carbon-carbon double bond within a molecular at a ratio in the range of 70 to 90 mol% with respect to 100 mol% of the hydroxyl group-containing monomer, and then curing by irradiating with an ultraviolet ray from the base side, and the die-bonding film is formed from an epoxy resin.

Since the pressure-sensitive adhesive layer is cured by ultraviolet ray irradiation after pasting onto the die-bonding film, it is pasted in a laminated state of which the mutual adhesion is not deteriorated while maintaining a good peeling property between the pressure-sensitive adhesive layer and the die-bonding film. Accordingly, the adhesive property of both is prevented from excessively deteriorating, and occurrence of chip fly can be prevented even when a semiconductor chip having a chip size of less than 1 mm x 1 mm by dicing is produced, for example.
Since the pressure-sensitive adhesive layer is in a cured state, destruction of the interface between the pressure-sensitive adhesive layer and the die-bonding film can be easily brought about. As a result, the peeling property between them is made to be good, and the pickup property is excellent even when picking up a very thin semiconductor chip of 25 to 75 µm thickness.

Since the die-bonding film is formed from an epoxy resin, the adhesive constituting the die-bonding film is prevented from overflowing onto the cut face even when the die-bonding film is cut together with the semiconductor wafer by dicing, for example. Accordingly, the cut faces are prevented from re-attaching to each other (blocking), which makes it possible to have more preferable picking up of the semiconductor chip.

Since an acrylic ester is used in the pressure-sensitive adhesive layer as a main monomer, a decrease of peeling strength can be attempted, and a good picking property can be possible. Furthermore, by setting the compounded ratio of a hydroxyl group-containing monomer to 10 mol% or more with respect to 100 mol% of the acrylic ester, the crosslinking after the ultraviolet ray irradiation is prevented from becoming insufficient.
As a result, adhesive residue can be prevented from occurring on a dicing ring that is pasted onto the pressure-sensitive adhesive layer when dicing, for example. On the other hand, by setting the compounded ratio to 40 mol% or less, it can be prevented that the pickup property deteriorates due to peeling becoming difficult by crosslinking due to the ultraviolet ray irradiation excessively proceeding. Further, productivity can be prevented from decreasing due to partial gelatinization of the polymer.

Since an isocyanate compound having a radical reactive carbon-carbon double bond in place of the multi-functional monomer is adopted in the present invention, there is no material diffusion of the multi-functional monomer into the die-bonding film. As a result, the interface between the dicing film and the die-bonding film is prevented from disappearing, which makes it possible to have a more preferable pickup property.

It is preferable that the cumulative radiation of the ultraviolet ray irradiation is in a range of 30 to 1000 mJ/cm². By setting the ultraviolet ray irradiation to 30 mJ/cm² or more, the pressure-sensitive adhesive layer is sufficiently cured and is prevented from excessively adhering to the die-bonding film. As a result, a good pickup property can be obtained, and attaching of the pressure-sensitive adhesive (so-called adhesive residue) on the die-bonding film after picking up can be prevented.
On the other hand, by setting the ultraviolet ray irradiation to 1000 mJ/cm² or less, thermal damage to a base can be reduced. It can be prevented that expansion property deteriorates due to the tensile modulus becoming too large by curing of the pressure-sensitive adhesive layer proceeding excessively. The adhesive strength is prevented from becoming too low, and thus, occurrence of chip fly is prevented when a workpiece is diced.

It is preferable that the acrylic ester is represented by CH₂=CHCOOR (wherein R is an alkyl group having 6 to 10 carbon atoms). When CH₂=CHCOOR (wherein R is an alkyl group having 6 to 10 carbon atoms) is used as the acrylic ester, it can be prevented that the peeling strength becomes too large and the pickup property deteriorates.

It is preferable that the hydroxyl group-containing monomer is at least any one selected from a group consisting of 2-hydroxyethyl (meth)acrylate, 2-hydroxypropyl (meth)acrylate, 4-hydroxybutyl (meth)acrylate, 6-hydroxyhexyl (meth)acrylate, 8-hydorxyoctyl (meth)acrylate, 10-hydroxydecyl (meth)acrylate, 12-hydroxylauryl (meth)acrylate, and (4-hydroxymethyleyclohexyl)methyl (meth)acrylate.

It is also preferable that the isocyanate compound having a radical reactive carbon-carbon double bond is at least one of 2-methacryloyloxyethyl isocyanate and 2-acrylolyloxyethyl isocyanate.

It is also preferable that the weight average molecular weight of the acrylic polymer is in a range of 350,000 to 1,000,000. By setting the weight average molecular weight to 350,000 or more, the acrylic polymer is prevented from becoming a low molecular weight polymer, and thus, peeling from the dicing ring that is pasted onto the pressure-sensitive adhesive layer can be prevented from occurring during dicing, for example.
Furthermore, since the crosslinking after the ultraviolet ray irradiation is prevented from becoming insufficient, adhesive residue can be prevented from occurring when peeling the dicing ring from the pressure-sensitive adhesive layer. On the other hand, by setting the weight average molecular weight to 1,000,000 or less, workability when forming the pressure-sensitive adhesive layer onto the base can be improved. The formation of the pressure-sensitive adhesive layer is performed by applying a solution of a pressure-sensitive adhesive composition containing the above-described polymer onto the base and then drying, for example. This is since the workability during polymerization application of the polymer and decreases when the weight average molecular weight of the polymer exceeds 1,000,000 since the viscosity of the solution of the pressure-sensitive adhesive composition becomes too high.

It is also preferable that the tensile modulus at 23 °C of the pressure-sensitive adhesive layer after ultraviolet ray irradiation is in the range of 7 to 170 MPa. By setting the tensile modulus (23 °C) to 7 MPa or more, a good pickup property can be maintained. On the other hand, by setting the tensile modulus to 170 MPa or less, occurrence of chip fly when dicing can be suppressed.

It is also preferable that the acrylic polymer constituting the pressure-sensitive adhesive layer does not contain an acrylic acid as a monomer component. Accordingly, the reaction and the interaction of the pressure-sensitive adhesive layer and the die-bonding film can be prevented, and the pickup property can be further improved.

In order to solve the above-mentioned problems, the present invention relates to a method for manufacturing a dicing die-bonding film having a dicing film having a pressure-sensitive adhesive layer on an ultraviolet-ray transmitting base and a die-bonding film provided on the pressure-sensitive adhesive layer, comprising a step of forming on the base a pressure-sensitive adhesive layer precursor containing a polymer containing an acrylic ester as a main monomer, a hydroxyl group-containing monomer at a ratio in the range of 10 to 40 mol% with respect to 100 mol% of the acrylic ester, and an isocyanate compound having a radical reactive carbon-carbon double bond within a molecular at a ratio in the range of 70 to 90 mol% with respect to 100 mol% of the hydroxyl group-containing monomer, a step of pasting the die-bonding film onto the pressure-sensitive adhesive layer precursor, and a step of forming the pressure-sensitive adhesive layer pasted the die-bonding film by irradiating the pressure-sensitive adhesive layer precursor with an ultraviolet ray from the base side.

In the manufacturing method of the present invention, the pressure-sensitive adhesive layer is formed by pasting the die-bonding film and then by curing by irradiating an ultraviolet ray. Accordingly, since a laminated state in which the adhesion between the die-bonding film and the pressure-sensitive adhesive layer is not deteriorated is maintained, the pressure-sensitive adhesive layer can be produced preventing an excessive decrease in the adhesive property.
As a result, occurrence of chip fly can be prevented even when a semiconductor chip having a chip size of less than 1 mm x 1 mm by dicing is produced, for example. Since the pressure-sensitive adhesive layer is cured, destruction of the interface between the pressure-sensitive adhesive layer and the die-bonding film can be easily brought about. As a result, the peeling property between them is made to be good, and the pickup property is excellent even when picking up a very thin semiconductor chip of 25 to 75 µm thickness.

Since an epoxy resin is used as a constituting material of the die-bonding film in this method, for example, when dicing a semiconductor wafer, a die-bonding film is formed that can prevent overflow of the adhesive from occurring onto its cut face even when the semiconductor wafer and the die-bonding film are cut. As a result, the cut faces in the die-bonding film are prevented from re-attacliing to each other (blocking), and thus, a dicing die-bonding film having an excellent pickup property can be produced.

Since the acrylic ester is used as a main monomer as a constituting material of the pressure-sensitive adhesive layer, a decrease of peeling strength can be attempted, and a good picking property can be possible. Furthermore, by setting the compounded ratio of a hydroxyl group-containing monomer to 10 mol% or more with respect to 100 mol% of an acrylic ester, the crosslinking after the ultraviolet ray irradiation is prevented from becoming insufficient.
As a result, adhesive residue can be prevented from occurring on a dicing ring that is pasted onto the pressure-sensitive adhesive layer when dicing, for example. On the other hand, by setting the compounded ratio to 40 mol% or less, it can be prevented that the pickup property deteriorates due to peeling becoming difficult by crosslinking due to the ultraviolet ray irradiation excessively proceeding. Further, productivity can be prevented from decreasing due to partial gelatinization of the polymer.

Since an isocyanate compound having a radical reactive carbon-carbon double bond within a molecular in place of the multi-functional monomer is adopted in the present invention, there is no material diffusion of the multi-functional monomer into the die-bonding film. As a result, the interface between the dicing film and the die-bonding film is prevented from disappearing, which makes it possible to have a more preferable pickup property.

The irradiation of the ultraviolet ray is preferably performed in the range of 30 to 1000 mJ/cm². By setting the irradiation of an ultraviolet ray to 30 mJ/cm² or more, the pressure-sensitive adhesive layer is sufficiently cured and is prevented from excessively adhering to the die-bonding film. As a result, a good pickup property can be obtained, and attaching of the pressure-sensitive adhesive (so-called adhesive residue) on the die-bonding film after picking up can be prevented.
On the other hand, by setting the irradiation of an ultraviolet ray to 1000 mJ/cm² or less, thermal damage to a base can be reduced. It can be prevented that expansion property deteriorates due to the tensile modulus becoming too large by curing of the pressure-sensitive adhesive layer proceeding excessively. Furthermore, the adhesive strength is prevented from becoming too low, and thus, occurrence of chip fly is prevented when a workpiece is diced.

In order to solve the above-mentioned problems, the present invention relates to a method of manufacturing a semiconductor device using a dicing die-bonding film comprising a dicing film having a pressure-sensitive adhesive layer on a base and a die-bonding film provided on the pressure-sensitive adhesive layer, wherein the dicing die-bonding film is prepared, and comprising a step of press-pasting a semiconductor wafer onto the die-bonding film, a step of forming a semiconductor chip by dicing the semiconductor wafer together with the die-bonding film, and a step of peeling the semiconductor chip together with the die-bonding film off the pressure-sensitive adhesive layer, and wherein the pressure-sensitive adhesive layer is not irradiated with the ultraviolet ray from the step of press-pasting the semiconductor wafer to the step of peeling off the semiconductor chip.

Since a dicing die-bonding film having an excellent pickup property as well as preventing occurrence of chip fly of a semiconductor chip when dicing a semiconductor wafer is used in the above-described method, the semiconductor chip can be easily peeled off from the dicing film together with the die-bonding film, for example, even in the case of a large semiconductor chip that is 10 mm x 10 mm or more or a very thin semiconductor chip of 25 to 75 µm thickness. That is, when the above-described method is used, a semiconductor device can be manufactured with an increased yield.

Further, there is no necessity to irradiate the pressure-sensitive adhesive layer with the ultraviolet ray before picking up with this method. As a result, the number of steps can be reduced compared with the conventional method for manufacturing a semiconductor device. Even in the case of the semiconductor wafer having a prescribed circuit pattern, the generation of circuit pattern failure caused by the irradiation of the ultraviolet ray can be prevented. As a result, a semiconductor device having high reliability can be manufactured.

Since a dicing die-bonding film having a die-bonding film using an epoxy resin as a constituting material is used in this method, the re-attaching (blocking) of the cut faces caused by the overflow of the adhesive onto the cut faces of the die-bonding film can be prevented even when dicing the semiconductor wafer. As a result, peeling of the semiconductor chip becomes further easier, and the yield can be increased.

### BRIEF DESCRIPTION OF THE DRAWINGS

- Fig. 1: is a cross-sectional schematic drawing showing a dicing die-bonding film according to one embodiment of the present invention;
- Fig. 2: is a cross-sectional schematic drawing showing another dicing die-bonding film according to another embodiment of the present invention;
- Fig. 3A: is a cross-sectional schematic drawing showing an example in which a semiconductor wafer is mounted on the dicing die-bonding film with the die-bonding film interposed therebetween.
- Fig. 3B: is a cross-sectional schematic drawing showing an example in which the semiconductor wafer is diced into semiconductor chips.
- Fig. 3C: is a cross-sectional schematic drawing showing an example in which the semiconductor chip is pushed up with a needle.
- Fig. 3D: is a cross-sectional schematic drawing showing an example in which the semiconductor chip is picked up.
- Fig. 3E: is a cross-sectional schematic drawing showing an example in which the semiconductor chip is adhered and fixed to an adherend, and furthermore, the semiconductor chip is sealed with a sealing resin.

### DETAILED DESCRIPTION OF THE PREFERRED EMBODIMENTS

### (Dicing Die-Bonding Film)

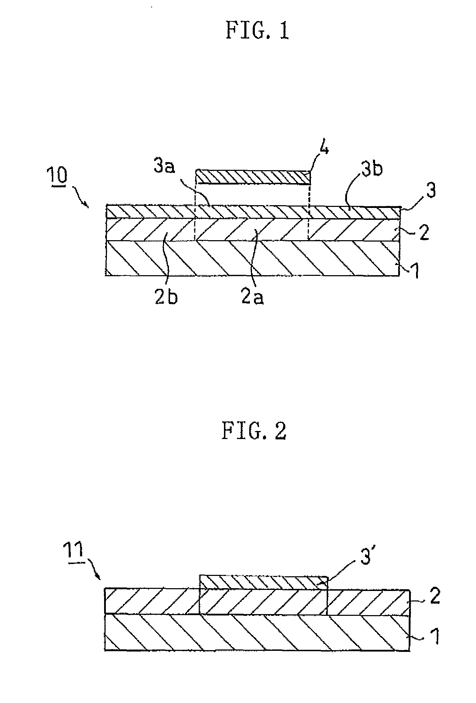

An embodiment of the present invention is described referring to Figs. 1 and 2. Fig. 1 is a sectional schematic drawing showing a dicing die-bonding film of the present embodiment. Fig. 2 is a sectional schematic drawing showing another dicing die-bonding film of the present embodiment. Parts that are unnecessary to explain are omitted, and there are parts that are drawn by magnifying or minifying to make the explanation easy.

As shown in Fig. 1, a dicing die-bonding film 10 has a configuration having a dicing film in which a pressure-sensitive adhesive layer 2 is provided on a base 1 and a die-bonding film 3 on the pressure-sensitive adhesive layer 2. Alternatively, as shown in Fig. 2, the present invention may have a configuration in which a die-bonding film 3' is formed only on a semiconductor wafer pasting portion.

The base 1 confers strength on the dicing die-bonding film 10, 11. Examples of the base film include polyolefins such as low-density polyethylene, linear polyethylene, middle-density polyethylene, high-density polyethylene, ultra-low-density polyethylene, random copolymerization polypropylene, block copolymerization polypropylene, homopolypropylene, polybutene, polymethyl pentene etc., polyesters such as ethylene/vinyl acetate copolymer, ionomer resin, ethylene/(meth)acrylic acid copolymer, ethylenel(meth)acrylate (random, alternating) copolymer, ethylene/butane copolymer, ethylene/hexene copolymer, polyurethane, polyethylene terephthalate, polyethylene naphthalate etc., polycarbonate, polyimide, polyether ether ketone, polyimide, polyether imide, polyamide, every aromatic polyamide, polyphenyl sulfide, aramid (paper), glass, glass cloth, fluorine resin, polyvinyl chloride, polyvinylidene chloride, cellulose resin, silicone resin, metal (foil), paper etc.

Further, an example of a material of the base 1 is a polymer such as a crosslinked body of the above-described resins. When the base 1 is composed of a plastic film, the plastic film may be used in a non-stretched form or after subjection if necessary to uniaxial or biaxial stretching treatment. According to a resin sheet endowed with thermal shrinkability by stretching treatment, the base 1 can be thermally shrunk after dicing thereby reducing the contact area between the pressure-sensitive adhesive layer 2 and the die-bonding film 3, 3' to facilitate the recovery of semiconductor chips.

The surface of the base 1 can be subjected to ordinary surface treatment for improving adhesion and maintenance of the adjacent layer, for example chemical or physical treatment such as treatment with chromate, exposure to ozone, exposure to flames, high-voltage electric shock exposure, and treatment with ionization radiations, or coating treatment with a undercoat (for example, a sticky material described later).

The same or different kinds of the base 1 can be suitably selected and used. The substrate material may be a single layer or multilayer or may be a blend substrate material having two or more kinds of resins dry-blended therein. The multilayer film can be produced from the above resin etc. by a conventional film lamination method such as co-extrusion method, dry lamination method etc. The base 1 can be provided thereon with a evaporated layer of about 30 to 500 Å consisting of an electroconductive material such as a metal, an alloy and an oxide thereof in order to confer antistatic performance. The base 1 may be a single layer or a multilayer consisting of two or more layers.

The thickness of the base 1 can be suitably determined without particular limitation, and is generally preferably about 5 to 200 µm.

The pressure-sensitive adhesive layer 2 is formed by an ultraviolet ray curing-type adhesive, and it is cured by the ultraviolet ray irradiation in advance. The cured portion is not necessarily the entire region of the pressure-sensitive adhesive layer 2, and at least a portion 2a corresponding to a semiconductor wafer pasting portion 3a of the pressure-sensitive adhesive layer 2 may be cured (see Fig. 1).
Because the pressure-sensitive adhesive layer 2 is cured by the ultraviolet ray irradiation before pasting with a die-bonding film 3, the surface thereof is hard, and the adhesion is suppressed from becoming excessively high at the interface of the pressure-sensitive adhesive layer 2 and the die-bonding film 3. Thus, the anchoring effect between the pressure-sensitive adhesive layer 2 and the die-bonding film 3 is decreased, and the peeling property can be improved.

By curing the ultraviolet ray curing-type pressure-sensitive adhesive layer 2 matching in the shape of a die-bonding film 3' shown in Fig. 2 in advance, the adhesion is suppressed from being excessively high at the interface of the pressure-sensitive adhesive layer 2 and the die-bonding film 3. Thus, the die-bonding film 3' has a characteristic of peeling easily off the pressure-sensitive adhesive layer 2 upon picking up. On the other hand, the other portion 2b of the pressure-sensitive adhesive layer 2 is non-cured because the ultraviolet ray has not irradiated it, and the adhesive strength is higher than the portion 2a. Thus, when pasting a dicing ring 12 to the other portion 2b, the dicing ring 12 can be certainly adhered and fixed.

As described above, in the pressure-sensitive adhesive layer 2 of the dicing die-bonding film 10 shown in Fig. 1, the portion 2b that is formed from a non-cured ultraviolet-ray curing-type pressure-sensitive adhesive adheres to the die-bonding film 3, and the holding strength upon dicing can be secured. In such a way, the ultraviolet-ray curing-type pressure-sensitive adhesive can support the die-bonding film 3 for fixing a semiconductor chip to an adherend such as a substrate with a good balance of adhesion and peeling. In the pressure-sensitive adhesive layer 2 of a dicing die-bonding film 11 shown in Fig. 2, the portion 2b can fix a dicing ring. A dicing ring that is made from a metal such as stainless steel or a resin can be used, for example.

In the dicing die-bonding film 10 when a semiconductor wafer is pasted to the die-bonding film 3, the adhesive strength of the portion 2a in the pressure-sensitive adhesive layer 2 to the semiconductor wafer pasting portion 3a is preferably designed to be smaller than the adhesive strength of the other portion 2b to a portion 3b that differs from the semiconductor wafer pasting portion 3a. The peeling adhesive strength of the portion 2a under a condition of a normal temperature of 23°C, a peeling angle of 15 degree, and a peeling speed of 300 mm/min is preferably 1 to 1.5 N/10 mm from the viewpoints of fixing and holding strength of the wafer, recovering property of a chip that is formed, and the like.
When the adhesive strength is less than 1 N/10 mm, the adhesion and fixing of a semiconductor chip having a chip size less than 1 mm x 1 mm becomes insufficient, and therefore chip fly may be generated upon dicing. When the adhesive strength exceeds 1.5 N/10 mm, the pressure-sensitive adhesive layer 2 excessively adheres the die-bonding film 3, and therefore the picking up of the semiconductor chip may become difficult. As a result, the adhesive strength is preferably 1 to 1.5 N/10 mm in view of manufacturing the semiconductor chip having a chip size less than 1 mm x 1 mm.
On the other hand, the adhesive strength of the other portion 2b is preferably 0.5 to 10 N/10 mm, and more preferably 1 to 5 N/10 mm. Even when the portion 2a has low adhesive strength, the generation of chip fly or the like can be suppressed by the adhesive strength of the other portion 2b, and the holding strength that is necessary for a wafer process can be exhibited.

In the dicing die-bonding film 11, the adhesive strength of the portion 2a in the pressure-sensitive adhesive layer 2 to the semiconductor wafer pasting portion 3a is preferably designed to be smaller than the adhesive strength of the other portion 2b to a dicing ring 12. The peeling adhesive strength of the portion 2a to the semiconductor pasting portion 3a (at a normal temperature of 23 °C, a peeling angle of 15 degree, and a peeling speed of 300 mm/min) is preferably 1 to 1.5 N/10 mm as the same as described above.
On the other hand, the adhesive strength of the other portion 2b to the dicing ring 12 is preferably 0.05 to 10 N/10 mm, and more preferably 0.1 to 5 N/10 mm. Even when the portion 2a has low adhesive strength, the generation of chip fly or the like can be suppressed by the adhesive strength of the other portion 2b, and the holding strength that is necessary for a wafer process can be exhibited. These adhesive strengths are based on a measured value at a normal temperature of 23 °C, a peeling angle of 15 degrees, and a tensile (peeling) speed of 300 mm/min.

In the dicing die-bonding films 10, 11, the adhesive strength of the wafer pasting portion 3a to the semiconductor wafer is preferably designed to be larger than the adhesive strength of the wafer pasting portion 3a to the portion 2a. The adhesive strength to the semiconductor wafer is appropriately adjusted depending on its type. The adhesive strength of the semiconductor wafer pasting portion 3a to the portion 2a (at a normal temperature of 23 °C, a peeling angle of 15 degrees, and a peeling speed of 300 mm/min) is preferably 0.05 to 10 N/10 mm, and more preferably 1 to 5 N/10 mm.
On the other hand, the adhesive strength of the semiconductor wafer pasting portion 3a to the semiconductor wafer (at a normal temperature of 23 °C, a peeling angle of 15 degrees, and a peeling speed of 300 mm/min) is preferably 0.5 to 15 N/10 mm, and more preferably 1 to 15 N/10 mm from the viewpoints of reliability upon dicing, picking up and die bonding as well as the pickup property.

When the diameter of a semiconductor wafer 4 is made to be r1, the diameter of the portion 2a in the pressure-sensitive adhesive layer 2 is made to be r₂, and the diameter of the semiconductor wafer pasting portion 3a in the die-bonding film 3 (or the die-bonding film 3') is made to be r₃, a relationship of r₁ < r₂ < r₃ is preferably satisfied. Thus, the entire face of the semiconductor wafer 4 can be adhered and fixed onto the die-bonding films 3, 3', and the peripheral part of the semiconductor wafer pasting portion 3a (or the die-bonding film 3') can be adhered and fixed to the other portion 2b. Because the adhesive strength of other portion 2b is higher than that of the portion 2a, the semiconductor wafer pasting portion 3a (or the die-bonding film 3') can be adhered and fixed at the peripheral part. As a result, the generation of chip fly can be further prevented upon dicing.

The ultraviolet ray curing-type pressure-sensitive adhesive is an internal-type ultraviolet ray curing-type adhesive that uses a base polymer having a radical reactive carbon-carbon double bond in a polymer side chain or a main chain or the ends of the main chain. Because the internal-type ultraviolet-ray curing-type adhesive does not have to include or does not include in a large amount an oligomer component or the like that is a low molecular weight component, the oligomer component or the like does not travel in the pressure-sensitive adhesive over time, and a pressure-sensitive adhesive layer having a stable layer structure can be formed.

In the present invention, the acrylic polymer includes an acrylic polymer having an acrylic ester as a main monomer component. Examples of the acrylic ester include alkyl acrylates (such as straight chain or branched chain alkyl esters having an alkyl group having 1 to 30 carbon atoms, especially 4 to 18 carbon atoms, such as methyl ester, ethyl ester, propyl ester, isopropyl ester, butyl ester, isobutyl ester, sec-butyl ester, t-butyl ester, pentyl ester, isopentyl ester, hexyl ester, heptyl ester, octyl ester, 2-ethylhexyl ester, isooctyl ester, nonyl ester, isononyl ester, decyl ester, isodecyl ester, undecyl ester, dodecyl ester, tridecyl ester, tetradecyl ester, hexadecyl ester, octadecyl ester, eicosyl ester, and behenyl ester) and cycloalkyl acrylates (such as cyclopentyl ester and cyclohexyl ester). These monomers may be used alone or two types or more may be used together.

Among the acrylic esters, a monomer represented by a chemical formula CH₂=CHCOOR (wherein R is an alkyl group having 6 to 10 carbon atoms, more preferably having 8 to 9 carbon atoms) is preferably used. When the number of carbon atoms is 6 or more, it can be prevented that the peeling strength becomes too large and the pickup property deteriorates. On the other hand, when the number of carbon atoms is 10 or less, it can be prevented that tackiness with the die-bonding film decreases, and as a result, there is a case that chip fly occurs upon dicing. Further, when the acrylic ester is represented by a chemical formula CH₂=CHCOOR, its compounded ratio is preferably 50 to 91 mol%, more preferably 80 to 87 mol% to 100 mol% of the acrylic ester of the acrylic polymer.
When the compounded ratio is less than 50 mol%, the peeling strength becomes too high, and there is a case that the pickup property deteriorates. On the other hand, when it exceeds 91 mol%, the adhesive property deteriorates, and there is a case that chip fly occurs upon dicing. Among the monomers represented by the above-described chemical formulae, acrylic 2-ethylhexyl and acrylic isooctyl are especially preferable.

A hydroxyl group-containing monomer that is capable of copolymerizing with the acrylic ester is used in the acrylic polymer as an essential component. Examples of the hydroxyl group-containing monomer include 2-hydroxyethyl (meth) acrylate, 2-hydroxypropyl (meth) acrylate, 4-hydroxybutyl (meth)acrylate, 6-hydroxyhexyl (meth)acrylate, 8-hydorxyoctyl (meth)acrylate, 10-hydroxydecyl (meth)acrylate, 12-hydroxylauryl (meth)acrylate, and (4-hydroxymethylcyelohexyl)methyl (meth)acrylate. These monomers may be used alone or two types or more may be used together.

The compounded ratio of the hydroxyl group-containing monomer is preferably in a range of 10 to 40 mol%, more preferably in a range of 15 to 30 mol% to 100 mol% of the acrylic ester. When the compounded ratio is less than 10 mol%, crosslinking after ultraviolet ray irradiation becomes insufficient, and there is a case that the pickup property deteriorates. On the other hand, when the compounded ratio exceeds 40 mol%, peeling becomes difficult because the polarity of the pressure-sensitive adhesive becomes high and the interaction with the die-bonding film becomes intense.

The acrylic polymer may include a unit corresponding to another monomer component that is capable of copolymerizing with the acrylic alkyl ester or the acrylic cycloalkyl ester as necessary for the purpose of improving cohesive strength and heat resistance.
Examples of such a monomer component include carboxyl group-containing monomers such as methacrylic alkyl esters such as methyl methacrylate, ethyl methacrylate, propyl methacrylate, isopropyl methacrylate, butyl methacrylate, isobutyl methacrylate, t-butyl methacrylate, s-butyl methacrylate and pentyl methacrylate; acrylic acid, methacrylic acid, carboxyethyl (meth)acrylate, carboxypentyl (meth)acrylate, itaconic acid, maleic acid, fumaric acid, and crotonic acid; anhydride monomers such as maleic anhydride and itaconic anhydride; sulfonic acid group-containing monomers such as styrene sulfonic acid, allylsulfonic acid, 2-(meth)acrylamide-2-methylpropanesulfonic acid, (meth)acrylamidepropanesulfonic acid, sulfopropyl (meth)acrylate, and (meth)acryloyloxynaphtalenesulfonic acid; phosphate group-containing monomers such as 2-hydroxyethylacryloylphosphate; acrylamide; acrylonitrile; methacrylic cycloalkyl ester.
One type or two types or more of these copolymerizable monomer components can be used. The amount of use of these copolymerizable monomers is preferably 40% by weight or less to the total monomer components. However, in the case of the carboxyl group-containing monomers, by its carboxyl group reacting with an epoxy group in an epoxy resin in the die-bonding film 3, the interface of the pressure-sensitive adhesive layer 2 and the die-bonding film 3 disappears, and the peeling property of both the pressure-sensitive adhesive layer 2 and the die-bonding film 3 may deteriorate.
Therefore, the amount of use of the carboxyl group-containing monomers is preferably 0 to 3% by weight or less of the total monomer component. Among these monomer components, the acrylic polymer constituting the pressure-sensitive adhesive layer 2 of the present invention preferably does not include acrylic acid as a monomer component. This is because there is a case that the peeling property deteriorates by disappearance of the interface between the pressure-sensitive adhesive layer 2 and the die-bonding film 3 by material diffusion of acrylic acid into the die-bonding film 3.

The acrylic polymer does not preferably include a multi-functional monomer as a monomer component for copolymerization. Accordingly, there is no material diffusion of the multi-functional monomer into the die-bonding film, the deterioration of the pickup property due to the interface of the pressure-sensitive adhesive layer 2 and the die-bonding film 3 disappearing can be prevented.

Further, an isocyanate compound having a radical reactive carbon-carbon double bond within a molecular is used in the acrylic polymer as an essential component. Examples of the isocyanate compound include methacryloyl isocyanate, 2-methacryloyloxyethyl isocyanate, 2-acryloyloxyethyl isocyanate and m-isopropenyl-α,α-dimethylbenzyl isocyanate.

The compounded ratio of the isocyanate compound having a radical reactive carbon-carbon double bond is preferably in a range of 70 to 90 mol%, and more preferably in a range of 75 to 85 mol% to 100 mol% of the hydroxyl group-containing monomer. When the compounded ratio is less than 70 mol%, crosslinking after ultraviolet-ray curing becomes insufficient, and there is a case that the pickup property deteriorates. On the other hand, when the compounded ratio exceeds 90 mol%, peeling becomes difficult because the polarity of the pressure-sensitive adhesive becomes high and the interaction with the die-bonding film becomes intense, and the pickup property deteriorates.

The acrylic polymer can be obtained by polymerizing the monomer mixture described above. The polymerization can be performed by any known method such as solution polymerization, emulsion polymerization, bulk polymerization, and suspension polymerization. The content of a low molecular weight material is preferably small from the viewpoint of minimizing the contamination of a clean adherend, or the like. In this respect, the weight average molecular weight of the acrylic polymer is preferably 350,000 to 1,000,000, and more preferably about 450,000 to 800,000. The measurement of the weight average molecular weight is performed by GPC (Gel Permeation Chromatography), and the value of the weight average molecular weight is calculated by polystyrene conversion.

Further, an external crosslinking agent can be appropriately adopted in the pressure-sensitive adhesive to adjust the adhesive strength before and after the ultraviolet ray irradiation. A specific method of external crosslinking is a method of adding and reacting a so-called crosslinking agent such as a polyisocyanate compound, an epoxy compound, an aziridine compound, or a melamine-based crosslinking agent. In the case of using an external crosslinking agent, its amount of use is appropriately determined by a balance with the base polymer that has to be crosslinked and further by the usage as a pressure-sensitive adhesive. In general, the amount is about 20 parts by weight or less to 100 parts by weight of the base polymer, and further, it is preferably compounded at 0.1 to 10 parts by weight. Furthermore, various conventionally known additives such as a tackifier and an anti-aging agent other than the above-described components may be used in the pressure-sensitive adhesive as necessary.

The method of introducing the radical reactive carbon-carbon double bond to the acrylic polymer is not especially limited, and various methods can be adopted. However, it is easy to introduce the radical reactive carbon-carbon double bond to the polymer side chain from the viewpoint of molecular design. An example thereof is a method of copolymerizing a monomer having a hydroxyl group to an acrylic polymer in advance and performing a condensation or addition reaction on the isocyanate compound having an isocyanate group that can react with this hydroxyl group and a radical reactive carbon-carbon double bond while maintaining the ultraviolet-ray curing property of the radical reactive carbon-carbon double bond.

In the internal type ultraviolet-ray curing-type pressure-sensitive adhesive, the base polymer (especially an acrylic polymer) having a radical reactive carbon-carbon double bond can be used alone. However, an ultraviolet-ray curable monomer component and an oligomer component may also be compounded at a level not deteriorating the characteristics.

The radiation-curing monomer component to be compounded includes, for example, urethane oligomer, urethane (meth)acrylate, trimethylol propane tri(meth)acrylate, tetramethylol methane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butane diol di(meth)acrylate, tetraethylene glycol di(meth)acrylate, 1,6-hexane diol (meth)acrylate, neopentyl glycol di(meth)acrylate etc.; ester acrylate oligomers; and isocyanurates or isocyanurate compounds such as 2-propenyl-3-butenyl cyanurate, tris(2-methacryloxyethyl) isocyanurate etc.
The radiation-curing oligomer component includes various acrylate oligomers such as those based on urethane, polyether, polyester, polycarbonate, polybutadiene etc., and their molecular weight is preferably in the range of about 100 to 30000. For the compounded amount of the radiation-curable monomer component or oligomer component, the amount of which the adhesive strength of the pressure-sensitive adhesive layer can be decreased can be determined appropriately depending on the type of the above-described pressure-sensitive adhesive layer. In general, the compounded amount is, for example, 5 to 500 parts by weight relative to 100 parts by weight of the base polymer such as an acrylic polymer constituting the pressure-sensitive adhesive, and preferably about 40 to 150 parts by weight.

For curing with UV rays, a photopolymerization initiator preferably is incorporated into the radiation-curing pressure-sensitive adhesive. The photopolymerization initiator includes, for example, α-ketol compounds such as 4-(2-hydroxyethoxy)phenyl(2-hydroxy-2-propyl)ketone, α-hydroxy-α,α'-dimethyl acetophenone, 2-methyl-2-hydroxypropiophenone, 1-hydroxycyclohexyl phenyl ketone etc.; acetophenone compounds such as methoxyacetophenone, 2,2-dimethoxy-2-phenylacetophenone, 2,2-diethoxyacetophenone, 2-methyl-1-[4-(methylthio)-phenyl]-2-morpholinopropane-1 etc.; benzoin ether compounds such as benzoin ethyl ether, benzoin isopropyl ether, anisoin methyl ether etc.; ketal compounds such as benzyl dimethyl ketal etc.; aromatic sulfonyl chloride compounds such as 2-naphthalene sulfonyl chloride etc.; optically active oxime compounds such as 1-phenone-1,1-propanedione-2-(o-ethoxycarbonyl)oxime etc.; benzophenone compounds such as benzophenone, benzoylbenzoic acid, 3,3'-dimethyl-4-methoxybenzophenone etc.; thioxanthone compounds such as thioxanthone, 2-chlorothioxanthone, 2-methyl thioxanthone, 2,4-dimethyl thioxanthone, isopropyl thioxanthone, 2,4-dichlorothioxanthone, 2,4-diethyl thioxanthone, 2,4-diisopropyl thioxanthone etc.; camphor quinone; halogenated ketone; acyl phosphinoxide; acyl phosphonate etc. The amount of the photopolymerization initiator to be incorporated is for example about 0.05 to 20 parts by weight, based on 100 parts by weight of the base polymer such as acrylic polymer etc. constituting the pressure-sensitive adhesive.

In the pressure-sensitive adhesive layer 2 of the dicing die-bonding film 10, a part of the pressure-sensitive adhesive layer 2 may be irradiated with the ultraviolet ray so that the adhesive strength of the portion 2a becomes smaller than the adhesive strength of another portion 2b. That is, the portion 2a can be formed where the adhesive strength is decreased by using the base 1 of which the entire or a part of the portion other than the portion corresponding to the semiconductor wafer pasting portion 3a on at least one side of the base 1 is shielded, forming the ultraviolet-ray curing-type pressure-sensitive adhesive layer 2 onto the base 1, and then curing the portion corresponding to the semiconductor wafer pasting portion 3a by ultraviolet ray irradiation. As the shielding material, a material that can be a photo mask on a support film can be manufactured by printing, vapor deposition, or the like.

When an impediment to curing due to oxygen occurs during the ultraviolet ray irradiation, it is desirable to shut off oxygen (air) from the surface of the ultraviolet-ray curing-type pressure-sensitive adhesive layer 2. Examples of the shut-off method include a method of coating the surface of the pressure-sensitive adhesive layer 2 with a separator and a method of performing irradiation with the ultraviolet ray in a nitrogen gas atmosphere.

The thickness of the pressure-sensitive adhesive layer 2 is not especially limited. However, it is preferably about 1 to 50 µm from the viewpoint of achieving both the prevention of the breakage of the chip cut face and the fixing and holding of the adhesive layer. The thickness is more preferably 2 to 30 µm, and further preferably 5 to 25 µm.

The die-bonding film 3 can be configured as only a single adhesive layer, for example. Further, the die-bonding film 3 may be of a multi-layer structure of two layers or more by appropriately combining thermoplastic resins having different glass transition temperatures and thermosetting resins having different thermosetting temperatures. Because cutting water is used in the dicing step of the semiconductor wafer, the die-bonding film 3 absorbs moisture, and there is a case that water is contained more than usual.
When the die-bonding film 3 is adhered to the substrate or the like at such a high water content, water vapor accumulates on the adhesion interface at the after curing stage, and there is a case that floating occurs. Therefore, such a problem can be avoided by making the adhesive for adhering the die have a configuration in which a core material having high moisture permeability is sandwiched with the die adhesive and making the water vapor diffuse through the film at the after curing stage. From such a viewpoint, the die-bonding film 3 may have a multi-layer structure in which the adhesive layer is formed on one side or both sides of the core material.

The melt viscosity of the die-bonding film 3 at 120 °C to 130 °C (the temperature condition during die bonding) is preferably 500 to 3500 MPa, more preferably 500 to 3300 MPa, and particularly preferably 500 to 3000 MPa. Accordingly, the generation of very small air bubbles (micro voids) and local sinks (hollows) can be prevented even in the case where a sufficient pressure cannot be applied on the peripheral part of the semiconductor chip when performing the die bond. As a result, the durability in the humidity resistance solder reflow test is improved, and it can be prevented that the semiconductor chip is damaged due to the mold resin entering into the peripheral part of the semiconductor chip.

The core material includes films such as a polyimide film, a polyester film, a polyethylene terephthalate film, a polyethylene naphthalate film, and a polycarbonate film, a glass fiber, a resin substrate reinforced with a plastic non-woven fiber, a silicon substrate, and a glass substrate.

The die-bonding film 3 according to the present invention is comprised by containing an epoxy resin as a main component. The epoxy resin is preferable from the viewpoint of containing fewer ionic impurities, etc. that corrode a semiconductor element. The epoxy resin is not particularly limited as long as it is generally used as an adhesive composition, and for example, a difunctional epoxy resin and a polyfunctional epoxy resin of such as a bispehnol A type, a bisphenol F type, a bisphenol S type, a brominated bisphenol A type, a hydrogenated bisphenol A type, a bisphenol AF type, a biphenyl type, a naphthalene type, a fluorine type, a phenol novolak type, an ortho-cresol novolak type, a trishydroxyphenylmethane type, and a tetraphenylolethane type epoxy resin or an epoxy resin of such as a hydantoin type, a trisglycidylisocyanurate type and a glycidylamine type epoxy resin are used. These can be used alone or two or more types can be used in combination. Among these epoxy resins, a novolak type epoxy resin, a biphenyl type epoxy resin, a trishydroxyphenylmethane type resin, and a tetraphenylolethane type epoxy resin are particularly preferable. This is because these epoxy resins have high reactivity with a phenol resin as a curing agent, and are superior in heat resistance, etc.

Further, other thermosetting resins and thermoplastic resins can be used together in the die-bonding film 3 appropriately as necessary. Examples of the thermosetting resins include phenol resins, amino resins, unsaturated polyester resins, polyurethane resins, silicone resins, and thermosetting polyimide resins. These resins can be used alone or two types or more can be used together. Further, phenol resins are preferably used as a curing agent for the epoxy resin.

Furthermore, the phenol resins act as a curing agent for the epoxy resin, and examples thereof include novolak phenol resins such as a phenol novolak resin, a phenol aralkyl resin, a cresol novolak resin, a tert-butylphenol novolak resin, and a nonylphenol novolak resin, resol phenol resins, and polyoxystyrenes such as polyparaoxystyrene. These can be used alone or two types or more can be used together. Among these phenol resins, a phenol novolak resin and a phenol aralkyl resin are especially preferable because they can improve connection reliability of a semiconductor device.

The compounded ratio of the epoxy resin and the phenol resin is preferably arranged so that the amount of a hydroxyl group in the phenol resin in 1 equivalent of the epoxy group in the epoxy resin component becomes 0.5 to 2.0 equivalents. The amount is more preferably 0.8 to 1.2 equivalents. That is, when the compounded ratio of both resins becomes out of this range, sufficient curing reaction does not proceed, and the characteristics of the epoxy resin cured compound easily deteriorate.

Examples of the thermoplastic resin include a natural rubber, a butyl rubber, an isoprene rubber, a chloroprene rubber, an ethylene-vinyl acetate copolymer, an ethylene-acrylic acid copolymer, an ethylene-acrylic ester copolymer, a polybutadiene resin, a polycarbonate resin, a thermoplastic polyimide resin, polyamide resins such as 6-nylon and 6,6-nylon, a phenoxy resin, an acrylic resin, saturated polyester resins such as PET and PBT, a polyamideimide resin, and a fluorine resin. These thermoplastic resins can be used alone or two types are more can be used together. Among these thermoplastic resins, especially preferable is an acrylic resin containing a small amount of ionic impurities and having high heat resistance and in which reliability of the semiconductor element can be secured.

The acrylic resin is not especially limited, and examples thereof include a polymer containing one type or two types or more of esters of acrylic acid or methacrylic acid having a straight chain or branched alkyl group having 30 carbon atoms or less, especially 4 to 18 carbon atoms. Examples of the alkyl group include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, an octadecyl group, and a dodecyl group.

Other monomers that form the polymer are not especially limited, and examples thereof include carboxyl group-containing monomers such as acrylic acid, methacrylic acid, carboxyethyl acrylate, carboxypentyl acrylate, itaconic acid, maleic acid, fumaric acid, and crotonic acid; acid anhydride monomers such as maleic anhydride and itaconic anhydride; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)-methylacrylate; sulfonic acid group-containing monomers such as styrenesulfonic acid, allylsulfonie acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid; and phosphoric acid group-containing monomers such as 2-hydroxyethylacryloyl phosphate.

Because the crosslinking is performed in the adhesive layer of the die-bonding film 3 to some extent in advance, a multi-functional compound that reacts with a functional group or the like of the molecular chain ends of the polymer is preferably added as a crosslinking agent upon manufacture. With this constitution, tackiness is improved under a high temperature and the heat resistance is improved.

Moreover, other additives can be appropriately compounded in the adhesive layer of the die-bonding film 3 as necessary. Examples of the other additives include a flame retardant, a silane coupling agent, and an ion trapping agent. Examples of the flame retardant include antimony trioxide, antimony pentoxide, and a brominated epoxy resin.
These can be used alone or two types or more can be used together. Examples of the silane coupling agent include β-(3,4-epoxycyclohexyl)ethyltrimethoxysilane, γ-glycidoxypropyltrimethoxysilane, and γ-glycidoxypropylmethyldiethoxysilane. These compounds can be used alone or two types or more can be used together. Examples of the ion trapping agent include hydrotalcites and bismuth hydroxide, These can be used alone or two types or more can be used together.

The thickness of the die-bonding film 3 is not particularly limited. However, it is about 5 to 100 µm, and preferably about 5 to 50 µm.

The dicing die-bonding film 10, 11 can have an antistatic property. This prevents the generation of static electricity during its adhesion and peeling, and prevents a circuit from being damaged by charging of the workpiece such as a semiconductor wafer due to the static electricity. The antistatic property can be given by an appropriate method such as a method of adding an antistatic agent or a conductive material into the base 1, the pressure-sensitive adhesive layer 2, or the die-bonding film 3, and a method of attaching a conductive layer made of a charge transfer complex, a metal film or the like to the base 1.
Among these methods, a method is preferable in which impurity ions that may change the quality of the semiconductor wafer are hardly generated. Examples of the conductive material (conductive filler) that is compounded to give electric conductivity, to improve thermal conductivity, and the like include sphere-shaped, needle-shaped, and flake-shaped metal powders of silver, aluminum, gold, copper, nickel, conductive alloys or the like, metal oxides of alumina or the like, amorphous carbon black, and graphite. However, the die-bonding film 3, 3' is preferably non-conductive from the viewpoint that the film can be made not to cause electric leakage.

The die-bonding film 3, 3' of the dicing die-bonding film 10, 11 is preferably protected by a separator (not shown in the drawings). The separator has a function as a protective material to protect the die-bonding film 3, 3' until the film is put to practical use. Further, the separator can be used also as a support base when the die-bonding film 3, 3' is transferred to the pressure-sensitive adhesive layer 2. The separator is peeled off when the workpiece is pasted onto the die-bonding film 3, 3' of the dicing die-bonding film. Polyethylene terephthalate (PET), polyethylene, polyprolylene, a plastic film whose surface is coated with a peeling agent such as a fluorine peeling agent or a long-chain alkylacrylate peeling agent, paper, and the like can also be used as the separator.

### Method of Manufacturing Dicing Die-Bonding Film

Next, a method of manufacturing the dicing die-bonding film of the present invention is explained using the dicing die-bonding film 10 as an example. First, the base 1 can be formed by a conventionally known film formation method. Examples of the film formation method include a calender film formation method, a casting method in an organic solvent, an inflation extrusion method in a sealed system, a T-die extrusion method, a co-extrusion method, and a dry lamination method.

Next, a pressure-sensitive adhesive layer precursor is formed by forming a coating film by applying a pressure-sensitive adhesive onto a base 1, and then by drying (by heat-crosslinking depending on necessity) the coating film under a prescribed condition. The application method is not particularly limited, and examples include roll coating, screen coating, and gravure coating. The drying condition can be set variously depending on the thickness, the material, etc. of the coating film.
Specifically, it is performed in the range of a drying temperature of 80 to 150 °C and a drying time of 0.5 to 5 minutes, for example. The pressure-sensitive adhesive layer precursor may be formed by forming a coating film by applying a pressure-sensitive adhesive onto a separator, and then by drying the coating film with the above-described condition. Then, the pressure-sensitive adhesive layer precursor is transferred onto the base 1.

Next, the die-bonding film 3 is formed by applying a forming material for forming the die-bonding film onto a peeling paper to have a prescribed thickness and drying it under a prescribed condition. The die-bonding film 3 is transferred onto the pressure-sensitive adhesive layer precursor.

Subsequently, ultraviolet ray irradiation is performed on the pressure-sensitive adhesive precursor from the substrate 1 side. Accordingly, the pressure-sensitive adhesive layer 2 is formed, and the dicing die-bonding film 10 of the present invention can be obtained. As the irradiation condition of the ultraviolet ray, the cumulative radiation is preferably in the range of 30 to 10,000 mJ/cm², and more preferably in the range of 100 to 500 mJ/cm². When the irradiation of the ultraviolet ray is less than 30 mJ/cm², there is a case where curing of the pressure-sensitive adhesive layer becomes insufficient.
As a result, the adhesion with the die-bonding film increases, and this causes a deterioration of the pickup property. Further, adhesive residue is generated in the die-bonding film after picking up. On the other hand, when the irradiation of the ultraviolet ray exceeds 10000 mJ/cm², there is a case where the base is thermally damaged. Further, the tensile modulus becomes too large by curing of the pressure-sensitive adhesive layer proceeding excessively, and the expansion property deteriorates. Furthermore, the adhesive strength becomes too low, and thus, there is a case where chip fly occurs when dicing the semiconductor wafer.

Moreover, it is preferable to have a step of standing the pressure-sensitive adhesive precursor in which the die-bonding film is laminated after the step of pasting the die-bonding film onto the pressure-sensitive adhesive layer precursor and before the step of the ultraviolet irradiation onto the pressure-sensitive adhesive layer precursor. Accordingly, the wettability in the interface of the pressure-sensitive adhesive layer precursor and the die-bonding film is improved, and the ultraviolet ray irradiation in a condition that oxygen etc. remains can be avoided. As a result, hindrance of the ultraviolet ray curing caused by oxygen is decreased, a region where the pressure-sensitive adhesive layer precursor is not cured with the ultraviolet ray can be prevented from being formed, and the peeling property over the surface can be made to be uniform.

The standing time (term) in the step of standing is 0.1 hours or more, preferably 0.5 hours or more, and more preferably 1 hours or more, particularly preferably 3 hours or more in a condition of being shielded from light, a temperature of 23 ± 5 C°, and a humidity of 55 ± 5% RH, for exmaple. Accordingly, the standing time is 6 hours or more, preferably 12 hours or more, and more preferably 24 hours or more in a condition of being shielded from light, a temperature of 23 ± 5 C°, and a humidity of 55 ± 5% RH.
When the standing time is less than 0.1 hours, the ultraviolet ray irradiation is performed in a condition of which the contact area of the pressure-sensitive adhesive layer precursor and the die-bonding film is small, and therefore, the adhesive strength of the pressure-sensitive adhesive layer to the die-bonding film decreases. As a result, there is a case where chip fly occurs when dicing. However, when the standing term exceeds 3 months, the contact area of the pressure-sensitive adhesive layer precursor and the die-bonding film becomes too large, and there is a case where the adhesive strength of the pressure-sensitive adhesive layer to the die-bonding film becomes too large. As a result, a good peeling property cannot be obtained, and there is a case where pickup failure occurs when picking up a semiconductor chip.

### Method of Manufacturing Semiconductor Device

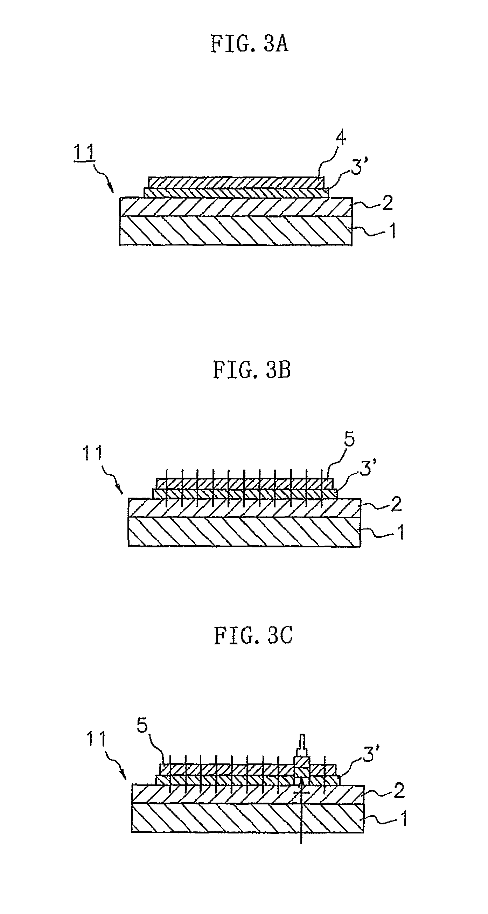

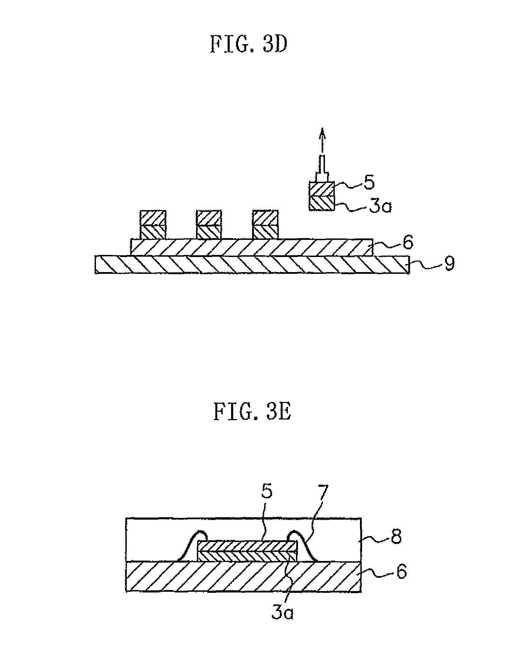

The method of manufacturing a semiconductor device using the dicing die-bonding film 11 of the present invention is explained by referring to Fig. 3.

First, a semiconductor wafer 4 is fixed onto the die-bonding film 3' in the dicing die-bonding film 11 by press-bonding and by adhering and holding (mounting step). The present step is performed while pressing with a pressing means such as a press-bonding roll.

Next, dicing of the semiconductor wafer 4 is performed. With this operation, a semiconductor chip 5 is formed by cutting the semiconductor wafer 4 into a prescribed size to make it into individual pieces. The dicing is performed following an ordinary method from the circuit face side of the semiconductor wafer 4, for example. Further, a cutting method, so-called full cut, in which cutting-in is performed to the dicing die-bonding film 10, can be adopted in the present step, for example.
The dicing apparatus that is used in the present step is not especially limited, and a conventionally known apparatus can be used. Further, because the semiconductor wafer is adhered and fixed by the dicing die-bonding film 10, chip breakage and chip fly can be suppressed, and at the same time, damage of the semiconductor wafer 4 can be suppressed. Even when cutting-in is performed to the pressure-sensitive adhesive layer 2 by dicing, the generation of scraps and the like can be prevented because the pressure-sensitive adhesive layer 2 is cured by the ultraviolet ray irradiation.

Next, expansion of the dicing die-bonding film 11 is performed. The expansion is performed using a conventionally known expanding apparatus. The expanding apparatus has a donut-shaped outer ring that can push the dicing die-bonding film 11 downwards through the dicing ring and an inner ring having a smaller diameter than the outer ring and supporting the dicing die-bonding film 11. Because only the portion 2a in the pressure-sensitive adhesive layer 2 is cured by the ultraviolet ray irradiation and the other portion 2b is not cured in the dicing die-bonding film 11, the space between the adjacent semiconductor chips can be sufficiently broadened without breaking. As a result, damage to the semiconductor chip by the semiconductor chips contacting to each other upon picking up, which is described later, can be prevented.

Picking up of the semiconductor chip 5 is performed to peel off the semiconductor chip that is adhered and fixed to the dicing die-bonding film 10. The method of picking up is not especially limited, and various conventionally known methods can be adopted. Examples thereof include a method of pushing up an individual semiconductor chip 5 from the dicing die-bonding film 10 side using a needle and picking up the semiconductor chip 5 that is pushed up with a picking up apparatus. Because the peeling property of the pressure-sensitive adhesive layer 2 and the die-bonding film 3 is good in the dicing die-bonding film 10, the pickup can be performed by reducing the number of needles and by increasing the yield even when the pushing up amount is small.

The semiconductor chip 5 that is picked up is adhered and fixed to an adherend 6 interposing the die-bonding film 3a therebetween (die bonding). The adherend 6 is loaded on a heat block 9. Examples of the adherend 6 include a lead frame, a TAB film, a substrate, and a semiconductor chip that is separately produced. The adherend 6 may be a deformable adherend that can be deformed easily or may be a non-deformable adherend such as a semiconductor wafer that is difficult to be deformed.

As the substrate, a conventionally known one can be used. Further, metal lead frames such as a Cu lead frame and a 42 Alloy lead frame and an organic substrate made of glass epoxy, BT (Bismaleimide-Triazine), polyimide, and the like can be used as the lead frame. However, the present invention is not limited to the above-described ones, and a circuit substrate is also included in which a semiconductor element is mounted and that can be used by being electrically connected with the semiconductor element.

When the die-bonding film 3 is of a thermosetting type, the heat resistant strength is improved by adhering and fixing the semiconductor chip 5 to the adherend 6 by heat-curing. The substrate or the like to which the semiconductor chip 5 is adhered and fixed interposing the semiconductor wafer pasting portion 3a therebetween can be subjected to a reflow step.
After that, wire bonding is performed to electrically connect the tip of the terminals (inner lead) of the substrate and an electrode pad (not shown in the drawings) on the semiconductor chip 5 with a bonding wire 7, the semiconductor chip is sealed with a sealing resin 8, and the sealing resin 8 is after-cured. With this operation, the semiconductor device of the present embodiment is produced.

Below, preferred examples of the present invention are explained in detail. However, materials, addition amounts, and the like described in these examples are not intended to limit the scope of the present invention, and are only examples for explanation as long as there is no description of limitation in particular. In the examples, the word "part(s)" represent "part(s) by weight", respectively, unless otherwise specified.

### Examples 1

### Production of Dicing Film

An acrylic polymer A having a weight average molecular weight of 850,000 was obtained by placing 88.8 parts of 2-ethylhexyl acrylate (in the following, referred to as "2EHA"), 11.2 parts of 2-hydroxyethyl acrylate (in the following, referred to as "HEA"), 0.2 parts of benzoyl peroxide, and 65 parts of toluene in a reactor equipped with a cooling tube, a nitrogen-introducing tube, a thermometer, and a stirring apparatus, and performing a polymerization treatment at 61°C in a nitrogen airflow for 6 hours. The weight average molecular weight is as follows. The molar ratio of 2EHA to HEA was made to be 100 mol : 20 mol.

An acrylic polymer A' was obtained by adding 12 parts (80 mol% to HEA) of 2-methacryloyloxyethyl isocyanate (in the following, referred to as "MOI") into this acrylic polymer A and performing an addition reaction treatment at 50°C in an air flow for 48 hours.

Next, a pressure-sensitive adhesive solution was produced by adding 8 parts of a polyisocyanate compound (trade name "CORONATE L" manufactured by Nippon Polyurethane Industry Co., Ltd.), and 5 parts of a photopolymerization initiator (trade name "IRGACURE 651" manufactured by Chiba Specialty Chemicals) into 100 parts of the acrylic polymer A'.

A pressure-sensitive adhesive layer precursor having a thickness of 10 µm was formed by applying the prepared pressure-sensitive adhesive solution onto the surface of a PET peeling liner where a silicone treatment was performed and heat-crosslinking at 120 °C for 2 minutes. Then, a polyolefin film having a thickness of 100 µm was pasted onto the corresponding surface of the pressure-sensitive adhesive layer precursor. Then, it was maintained at 50 °C for 24 hours.

### Production of Die-Bondin Film

A solution was prepared to have a concentration of 23.6% by weight by dissolving 50 parts of an epoxy resin (trade name "EPPN501HY", manufactured by Nippon Kayaku Co., Ltd.), 50 parts of a phenol resin (trade name "MEH7800", manufactured by Meiwa Plastic Industries, Ltd.), 100 parts of an acrylic copolymer (trade name "REBITAL AR31", weight average molecular weight of 700,000, glass transition point at -15°C, manufactured by Nogawa Chemical Co., Ltd.), and 70 parts of a spherical silica (trade name "S0-25R", average particle size of 0.5 µm, manufactured by Admatechs) into methylethylketone.

The solution of this adhesive composition was applied onto a releasing treatment film made from a polyethylene terephthalate film having a thickness of 50 µm on which a silicone releasing treatment was performed as a peeling liner (a separator), and it was dried at 130 °C for 2 minutes. Accordingly, a die-bonding film having a thickness of 25 µm was produced.

### Production of Dicing Die-Bonding Film

The above-described die-bonding film was transferred to the pressure-sensitive adhesive layer precursor side in the above-described dicing film. Subsequently, it was left for 24 hours under an environment of 25 ± 3 °C temperature and 85% or less relative humidity. Furthermore, the pressure-sensitive adhesive layer was formed by irradiating only the portion corresponding to the semiconductor wafer pasting portion (diameter 200 mm) of the pressure-sensitive adhesive layer precursor with an ultraviolet ray. Accordingly, the dicing die-bonding film of the present invention was produced. The irradiation condition of the ultraviolet ray was as follows.

### Irradiation Conditions of the Ultraviolet Rays

Ultraviolet ray (UV) irradiation apparatus: high pressure mercury lamp
Ultraviolet ray cumulative radiation: 500 mJ/cm²
Output: 75 W
Irradiation strength: 150 mW/cm²
The ultraviolet rays were radiated directly onto the pressure-sensitive adhesive layer precursor.

### Measurement of Weight Average Molecular Weight Mw>

The measurement of the weight average molecular weight Mw was performed by GPC (Gel Permeation Chromatography). The measurement condition is as follows. The weight average molecular weight was calculated by polystyrene conversion.

Measurement apparatus: HLC-8120GPC (trade name) manufactured by Tosoh Corporation
Column: TSKgel GMH-H(S) x 2 (product number) manufactured by Tosoh Corporation
Flow rate: 0.5 ml/min
Amount injected: 100 µl
Column temperature: 40 °C
Eluent: THF
Concentration of injected sample: 0.1% by weight
Detector: differential refractometer

### Examples 2 to 14

In each of Examples 2 to 14, a dicing die-bonding film was produced in the same manner as Example 1 except that the composition and the compounded ratio were changed to those shown in Table 1.

### Example 15

In the present example, a dicing die-bonding film was produced in the same manner as Example 1 except that the standing step after transferring the die-bonding film to the pressure-sensitive adhesive layer precursor of the dicing die-bonding film was performed under an environment of a temperature at 25 ± 3 °C and a relative humidity at 85% or less for 12 hours.

### Example 16

In the present example, a dicing die-bonding film was produced in the same manner as Example 1 except that the standing step after transferring the die-bonding film to the pressure-sensitive adhesive layer precursor of the dicing die-bonding film was performed under an environment of a temperature at 25 ± 3 °C and a relative humidity at 85% or less for 0.1 hours.

**Table 1**

| | ACRYLIC ESTER | | | | | HYDROXYL GROUP-CONTAIN ING MONOMER | | ISOCYANATE COMPOUND | | | | | |
|---|---|---|---|---|---|---|---|---|---|---|---|---|---|
| | 2EHA | i-OA | i-NA | BA | AA | HEA | 4HBA | MOI | AOI | TOLU ENE | C/L | T/C | PHOTOPOLY MERIZATION INITIATOR |
| EXAMPLE 1 | 88.8 (100) | - | - | - | - | 11.2 (20) | - | 12 (80) | - | 65 | 8 | - | 5 |
| EXAMPLE 2 | 93 (100) | - | - | - | - | 7 (12) | - | 7.8 (83) | - | 65 | 8 | - | 5 |
| EXAMPLE 3 | 84.1 (100) | - | - | - | - | 15.9 (30) | - | 17 (80) | - | 65 | 8 | - | 5 |
| EXAMPLE 4 | - | 88.8 (100) | - | - | - | 11.2 (20) | - | 12 (80) | - | 65 | 8 | - | 5 |
| EXAMPLE 5 | - | - | 89.5 (100) | | - | 10.5 (20) | - | 11.2 (80) | - | 65 | 8 | - | 5 |
| EXAMPLE 6 | 61.8 (62.5) | - | - | 25.8 (37.5) | - | 12.5 (20) | - | 13.3 (80) | - | 65 | 8 | - | 5 |
| EXAMPLE 7 | 89.5 (100) | - | - | - | - | - | 10.5 (15) | 9.1 (80) | - | 65 | 8 | - | 5 |
| EXAMPLE 8 | 88.8 (100) | - | - | - | - | 11.2 (20) | - | - | 10.9 (80) | 65 | 8 | - | 5 |
| EXAMPLE 9 | 88.8 (100) | - | - | - | - | 11.2 (20) | - | 10.5 (70) | - | 65 | 8 | - | 5 |
| EXAMPLE 10 | 88.8 (100) | - | - | - | - | 11.2 (20) | - | 13.5 (90) | - | 65 | 8 | - | 5 |
| EXAMPLE 11 | 91.1 (100) | - | - | - | 0.3 (0.8) | 8.6 (15) | - | 10.4 (90) | - | 65 | - | 0.5 | 5 |
| EXAMPLE 12 | 88.8 (100) | - | - | - | - | 11.2 (20) | - | 12 (80) | - | 100 | 8 | - | 5 |
| EXAMPLE 13 | 88.8 (100) | - | - | - | - | 11.2 (20) | - | 12 (80) | - | 40 | 8 | - | 5 |
| EXAMPLE 14 | 80.7 (100) | - | - | - | - | 19.3 (38) | - | 21.8 (84) | - | 65 | 8 | - | 5 |
| EXAMPLE 15 | 88.8 (100) | | | | | 11.2 (20) | | 12 (80) | | 65 | 8 | - | 5 |
| EXAMPLE 16 | 88.8 (100) | - | - | - | - | 11.2 (20) | - | 12 (80) | - | 65 | 8 | - | 5 |

The values in parentheses represent mol%. However, the values in parentheses for HEA and 4HBA represent mol% with respect to 100 mol% of the total amount of the acrylic ester. The values in parentheses for MOI and AOI represent mol% with respect to the hydroxyl group-containing monomer. The values in parentheses for AA represent mol% with respect to 100 mol% of the total amount of the acrylic ester.

The meaning of the abbreviations described in Table 1 and the following Table 2 is as follows.

2EHA: 2-ethylhexyl acrylate
i-OA: isooctyl acrylate
i-NA: isononyl acrylate
BA: n-butyl acrylate
AA: acrylic acid
HEA; 2-hydroxyethyl acrylate
4HBA: 4-hydroxybutyl acrylate
AOI: 2-acryloyloxyethyl isocyanate
C/L: a polyisocyanate compound (trade name "CORONATE L" manufactured by Nippon Polyurethane Industry Co., Ltd.)
T/C: Epoxy crosslinking agent (trade name "TETRAD-C" manufactured by Mitsubishi Gas Chemical Company, Inc.)

### Comparative Example 1

In the present comparative example, a pressure-sensitive adhesive layer precursor having a thickness of 10 µm was formed by applying the pressure-sensitive adhesive solution used in Example 1 onto the surface of a PET peeling liner where a silicone treatment was performed and heat-crosslinking at 120 °C for 2 minutes. Then, a polyolefin film having a thickness of 100 µm was pasted onto the corresponding surface of the pressure-sensitive adhesive layer precursor.
Then, it was maintained at 50 °C for 24 hours. Subsequently, a pressure-sensitive adhesive layer was formed by irradiating only a portion (220 mm diameter) corresponding to the wafer pasting portion (200 mm diameter) of the pressure-sensitive adhesive layer precursor with an ultraviolet ray. Accordingly, the dicing film according to the present comparative example was produced. The irradiation condition of the ultraviolet ray was the same as that in Example 1.

Next, a die-bonding film was produced in the same manner as Example 1. The dicing die-bonding film according to the present comparative example was obtained by transferring the die-bonding film to the pressure-sensitive adhesive layer side of the dicing film.

### Comparative Examples 2 to 14

In each of Comparative Examples 2 to 14, a dicing die-bonding film was produced in the same manner as Comparative Example 1 except that the composition and the compounded ratio were changed to those shown in Table 2.

### Comparative Example 15

In the present comparative example, a pressure-sensitive adhesive layer precursor having a thickness of 10 µm was formed by applying the pressure-sensitive adhesive solution used in Example 1 onto the surface of a PET peeling liner where a silicone treatment was performed and heat-crosslinking at 120 °C for 2 minutes. Subsequently, a polyolefin film having a thickness of 100 µm was pasted onto the corresponding surface of the pressure-sensitive adhesive layer precursor. After that, it was maintained at 50 °C for 24 hours.

Next, a die-bonding film was produced in the same manner as Example 1. The die-bonding film was transferred to the pressure-sensitive adhesive layer side of the dicing film. Then, a pressure-sensitive adhesive layer was formed by irradiating only a portion (220 mm diameter) corresponding to the wafer pasting portion (200 mm diameter) of the pressure-sensitive adhesive layer precursor with an ultraviolet ray. Accordingly, the dicing film according to the present comparative example was produced. The irradiation condition of the ultraviolet ray was the same as that in Example 1.

**Table 2**

| | ACRYLIC ESTER | | | | | HYDROXYL GROUP-CONTAINING MONOMER | | ISOCYANATE COMPOUND | | | | | |
|---|---|---|---|---|---|---|---|---|---|---|---|---|---|
| | 2EHA | i-OA | i-NA | BA | AA | HEA | 4HBA | MOI | AOI | TOLUEN E | C/L | T/C | PHOTOPOLYMERIZATION INITIATOR |
| COMPA RATIVE EXAMPLE 1 | 88.8 (100) | - | - | - | - | 11.2 (20) | - | 12 (80) | - | 65 | 8 | - | 5 |
| COMPA RATIVE EXAMPLE 2 | 93 (100) | - | - | - | - | 7 (12) | - | 7.8 (83) | - | 65 | 8 | - | 5 |
| COMPA RATIVE EXAMPLE 3 | 84.1 (100) | - | - | - | - | 15.9 (30) | - | 17 (80) | - | 65 | 8 | - | 5 |
| COMPA RATIVE EXAMPLE 4 | - | 88.8 (100) | - | - | - | 11.2 (20) | - | 12 (80) | - | 65 | 8 | - | 5 |
| COMPA RATIVE EXAMPLE 5 | - | - | 89.5 (100) | | - | 10.5 (20) | - | 11.2 (80) | - | 65 | 8 | - | 5 |
| COMPA RATIVE EXAMPLE 6 | 61.8 (62.5) | - | - | 25.8 (37.5) | - | 12.5 (20) | - | 13.3 (80) | - | 65 | 8 | - | 5 |
| COMPA RATIVE EXAMPLE 7 | 89.5 (100) | - | - | - | - | - | 10.5 (15) | 9.1 (80) | - | 65 | 8 | - | 5 |
| COMPA RATIVE EXAMPLE 8 | 88.8 (100) | - | - | - | - | 11.2 (20) | - | - | 10.9 (80) | 65 | 8 | - | 5 |
| COMPA RATIVE 9 | 88.8 (100) | - | - | - | - | 11.2 (20) | - | 10.5 (70) | - | 65 | 8 | - | 5 |
| COMPA RATIVE EXAMPLE 10 | 88.8 (100) | - | - | - | - | 11.2 (20) | - | 13.5 (90) | - | 65 | 8 | - | 5 |
| COMPA RATIVE EXAMPLE 11 | 91.1 (100) | - | - | - | 0.3 (0.8) | 8.6 (15) | - | 10.4 (90) | - | 65 | - | 0.5 | 5 |
| COMPA RATIVE EXAMPLE 12 | 88.8 (100) | - | - | - | - | 11.2 (20) | - | 12 (80) | - | 100 | 8 | - | 5 |
| COMPA RATIVE EXAMPLE 13 | 88.8 (100) | - | - | - | - | 11.2 (20) | - | 12 (80) | - | 40 | 8 | - | 5 |
| COMPA RATIVE EXAMPLE 14 | 80.7 (100) | - | - | - | - | 19.3 (38) | - | 21.8 (84) | - | 65 | 8 | - | 5 |
| COMPA RATIVE EXAMPLE 15 | 88.8 (100) | - | - | - | - | 11.2 (20) | - | 6 (40) | - | 65 | 8 | - | 5 |

The values in parentheses represent mol%. However, the values in parentheses for HEA and 4HBA represent mol% with respect to 100 mol% of the total amount of the acrylic ester. The values in parentheses for MOI and AOI represent mol% with respect to the hydroxyl group-containing monomer. The values in parentheses for AA represent mol% with respect to 100 mol% of the total amount of the acrylic ester.

### Dicing

Dicing of the semiconductor was actually performed in the following manner using each of the dicing die-bonding films of the Examples and Comparative Examples, and performance of each dicing die-bonding film was evaluated.

A backside polishing treatment was performed on a semiconductor wafer (8 inch diameter and 0.6 mm thickness), and a mirror wafer having a thickness of 0.15 mm was used as a workpiece. The separator was peeled off from the dicing die-bonding film, the mirror wafer was pasted onto the die-bonding film by roll press-bonding at 40 °C, and dicing was performed. Further, the dicing was performed to full-cut so that the chips had a size of 1 mm². Whether there was chip fly or not was confirmed on the semiconductor wafer and on the dicing die-bonding film after cutting. Chip fly was evaluated in the following manner: the case where even one semiconductor chip flew is marked as x and the case where no semiconductor chip flew is marked as O. The wafer grinding condition, the pasting condition, and the dicing condition will be described later.

### Wafer Grinding Condition

Grinding apparatus: DFG-8560 manufactured by DISCO Corporation
Semiconductor wafer: 8 inch in diameter (the backside was polished to a thickness of 0.6 mm to 0.15 mm.)

### Pasting Conditions

Pasting apparatus: MA-3000II manufactured by Nitto Seki Co., Ltd.
Pasting speed: 10 mm/min
Pasting pressure: 0.15 MPa
Stage temperature during pasting: 40 °C

### Dicing Conditions

Dicing apparatus: DFD-6361 manufactured by DISCO Corporation
Dicing ring: 2-8-1 manufactured by DISCO Corporation
Dicing speed: 80 mm/sec

### Dicing blade:

Z1: 2050HEDD manufactured by DISCO Corporation
Z2: 2050HEBB manufactured by DISCO Corporation

### Dicing blade rotational speed:

Z1: 40,000 rpm
Z2: 40,000 rpm

### Blade height:

Z1: 0.215 mm (depending on the thickness of the semiconductor wafer (When the wafer thickness is 75 µm, it is 0.170 mm.))
Z2: 0.085 mm

Cutting method: A mode / Step cut
Wafer chip size: 0.5 mm square

### Picking Up

The picking up was actually performed after the dicing of the semiconductor wafer was performed in the following manner using each of the dicing die-bonding films of the Examples and Comparative Examples, and performance of each dicing die-bonding film was evaluated.

A backside polishing treatment was performed on a semiconductor wafer (8 inch diameter and 0.6 mm thickness), and a mirror wafer having a thickness of 0.075 mm was used as a workpiece. The separator was peeled off from the dicing die-bonding film, the mirror wafer was pasted onto the die-bonding film by roll press-bonding at 40 °C, and dicing was performed. The dicing was performed to full-cut so that the chips had a size of 10 mm².

Next, an expansion step was performed by stretching each dicing die-bonding film to make the space between chips a prescribed interval. However, the expansion step was performed on the dicing die-bonding film of Comparative Example 8 after performing the ultraviolet ray irradiation. As the irradiation condition of the ultraviolet ray, UM-810 (trade name, manufactured by Nitto Seiki Co., Ltd.) was used as the ultraviolet ray (UV) irradiation apparatus and the cumulative radiation of the ultraviolet ray was set to be 300 mJ/cm². The ultraviolet ray irradiation was performed from the polyolefin film side.

Evaluation of the pickup property was performed by picking up the semiconductor chip with a method of pushing up the semiconductor chip by a needle from the base side of each dicing die-bonding film. Specifically, 400 semiconductor chips were continuously picked up, and the case where the success rates when the evaluations were performed in both conditions A and B described later were 100% was marked as ⊙, the case where the success rate when the evaluation was performed in condition A was 100% and when the evaluation was performed in condition B was not 100% was marked as ○, and the case where the success rates when the evaluations were performed in both conditions A and B were not 100% was marked as x.

### Wafer Grinding Condition

Grinding apparatus; DFG-8560 manufactured by DISCO Corporation
Semiconductor wafer: 8 inch diameter (the backside was polished to a thickness of 0.6 mm to 0.075 mm.)

### Pasting Condition

Pasting apparatus: MA-3000II manufactured by Nitto Seki Co., Ltd.
Pasting speed: 10 mm/min
Pasting pressure: 0.15 MPa
Stage temperature during pasting: 40°C

### Dicing Condition

Dicing apparatus: DFD-6361 manufactured by DISCO Corporation
Dicing ring: 2-8-1 manufactured by DISCO Corporation
Dicing speed: 80 mm/sec

### Dicing blade:

Z1: 2050HEDD manufactured by DISCO Corporation
Z2: 2050HEBB manufactured by DISCO Corporation

### Dicing blade rotational speed:

Z1: 40,000 rpm
Z2: 40,000 rpm

### Blade height:

Z1: 0.170 mm (depending on the thickness of the semiconductor wafer (When the wafer thickness is 75 µm, it is 0.170 mm.))
Z2: 0.085 mm

Cutting method: A mode / Step cut
Wafer chip size: 10.0 mm²

### Picking Up Condition

The picking up was performed in the conditions A and B shown in the following Table 3.

**Table 3**

| | CONDITION A | CONDITION B |
|---|---|---|
| NEEDLE | TOTAL LENGTH 10 mm, DIAMETER 0.7 mm, SHARP ANGLE 15 degrees, TIP R 350 µm | SAME AS LEFT |
| NUMBER OF NEEDLES | 5 | 5 |
| NEEDLE PUSHING UP AMOUNT (µm) | 350 | 200 |
| NEEDLE PUSHING UP SPEED (mm/sec) | 5 | 5 |
| COLLET MAINTAINING TIME (msec) | 200 | 200 |
| EXPANDING SPEED (mm/sec) | 3 | 3 |

### Method of Measuring Tensile Modulus

As the measurement condition, the sample size was set to be an initial length of 10 mm and a sectional area of 0.1 to 0.5 mm², the measurement temperature was set to 23 °C, the distance to the chuck was set to 50 mm, the tensile test was performed in the MD direction or the TD direction at a tensile speed of 50 mm/min, and the variation (mm) in elongation of the sample in each direction was measured. As a result, the tensile modulus was obtained by drawing a tangent line at the initial rising part of the obtained S-S curve and dividing the tensile strength when the tangent line corresponds to 100 % elongation by the sectional area of the base film. A film in which the die-bonding film was peeled off from the dicing die-bonding film was used for each sample.

### Adhesive Residue of Dicing Ring

The dicing film was peeled off the dicing ring, and whether or not an adhesive residue was generated on the dicing ring was visibly confirmed. The case that an adhesive residue was confirmed was marked as poor, and the case that it was not confirmed was marked as good.

### Peeling Adhesive Strength

A sample piece having a width of 10 mm was cut out from each dicing die-bonding film, and was pasted onto a silicon mirror wafer placed on a hot plate at 40 °C. After the sample piece was left for about 30 minutes, the peeling adhesive strength was measured using a tensile test machine. The measurement conditions were a peeling angle of 15° and a tensile speed of 300 mm/min. Conservation and measurement of the peeling adhesive strength of the sample piece were performed under an environment of a temperature of 23 °C and a relative humidity of 50%.

**Table 4**

| | Mw (ten thousands) | UV IRRADIATION | STANDING TIME (hr) | TENSILE MODULUS (MPa) AFTER UV CURE (MPa) | PICKUP PROPERTY | CHIP FLY | | ADHESIVE RESIDUE ON DICING RING | PEELING ADHESIVE STRENGTH (N/10 mm) |
|---|---|---|---|---|---|---|---|---|---|
| | | | | | | NUMBER OF OCCURANCES | OCCURANCE RATE (%) | | |
| EXAMPLE 1 | 58 | IRRADIATION AFTER PASTING DIE-BONDING FILM | 24 | 19.7 | ⊙ | 0/15 | 0 | ○ | 1.2 |
| EXAMPLE 2 | 56 | IRRADIATION AFTER PASTING DIE-BONDING FILM | 24 | 11.3 | ⊙ | 0/15 | 0 | ○ | 1.3 |
| EXAMPLE 3 | 62 | IRRADIATION AFTER PASTING DIE-BONDING FILM | 24 | 85.1 | ⊙ | 0/15 | 0 | ○ | 1.1 |
| EXAMPLE 4 | 58 | IRRADIATION AFTER PASTING DIE-BONDING FILM | 24 | 19.3 | ⊙ | 0/15 | 0 | ○ | 1.2 |
| EXAMPLE 5 | 56 | IRRADIATION AFTER PASTING DIE-BONDING FILM | 24 | 19.1 | ⊙ | 0/15 | 0 | ○ | 1.2 |
| EXAMPLE 6 | 71 | IRRADIATION AFTER PASTING DIE-BONDING FILM | 24 | 50.4 | ○ | 0/15 | 0 | ○ | 1.4 |
| EXAMPLE 7 | 63 | IRRADIATION AFTER PASTING DIE-BONDING FILM | 24 | 17.6 | ⊙ | 0/15 | 0 | ○ | 1.1 |
| EXAMPLE 8 | 58 | IRRADIATION AFTER PASTING DIE-BONDING FILM | 24 | 20.1 | ⊙ | 0/15 | 0 | ○ | 1.1 |
| EXAMPLE 9 | 58 | IRRADIATION AFTER PASTING DIE-BONDING FILM | 24 | 16.2 | ⊙ | 0/15 | 0 | ○ | 1.3 |
| EXAMPLE 10 | 59 | IRRADIATION AFTER PASTING DIE-BONDING FILM | 24 | 21.3 | ⊙ | 0/15 | 0 | ○ | 1.1 |
| EXAMPLE 11 | 62 | IRRADIATION AFTER PASTING DIE-BONDING FILM | 24 | 26.7 | ○ | 0/15 | 0 | ○ | 1.4 |
| EXAMPLE 12 | 41 | IRRADIATION AFTER PASTING DIE-BONDING FILM | 24 | 19.5 | ⊙ | 0/15 | 0 | ○ | 1.1 |
| EXAMPLE 13 | 83 | IRRADIATION AFTER PASTING DIE-BONDING FILM | 24 | 19.9 | ⊙ | 0/15 | 0 | ○ | 1.3 |
| EXAMPLE 14 | 64 | IRRADIATION AFTER PASTING DIE-BONDING FILM | 24 | 120 | ⊙ | 0/15 | 0 | ○ | 1.2 |
| EXAMPLE 15 | 58 | IRRADIATION AFTER PASTING DIE-BONDING FILM | 12 | 19.7 | ⊙ | 0/15 | 0 | ○ | 1.1 |
| EXAMPLE 16 | 58 | IRRADIATION AFTER PASTING DIE-BONDING FILM | 0.1 | 19.7 | ⊙ | 1/15 | 7 | ○ | 1.0 |

The standing time represents the time (hr) until irradiation of an ultraviolet ray after pasting the die-bonding film onto the pressure-sensitive adhesive layer precursor.

**Table 5**

| | Mw (ten thousands) | UV IRRADIATION | STANDING TIME (hr) | TENSILE MODULUS (MPa) AFTER UV CURE (MPa) | PICKUP PROPERTY | CHIP FLY | | ADHESIVE RESIDUE ON DICING RING | PEELING ADHESIVE STRENGTH (N/10 mm) |
|---|---|---|---|---|---|---|---|---|---|
| | | | | | | NUMBER OF OCCURANCES | OCCURANCE RATE (%) | | |
| COMPARATIVE EXAMPLE 1 | 58 | IRRADIATION BEFORE PASTING DIE-BONDING FILM | - | 19.7 | ⊙ | 3/15 | 20 | ○ | 0.8 |
| COMPARATIVE EXAMPLE 2 | 56 | IRRADIATION BEFORE PASTING DIE-BONDING FILM | - | 11.3 | ⊙ | 6/15 | 40 | ○ | 0.9 |
| COMPARATIVE EXAMPLE 3 | 62 | IRRADIATION BEFORE PASTING DIE-BONDING FILM | - | 85.1 | ⊙ | 3/15 | 20 | ○ | 0.8 |
| COMPARATIVE EXAMPLE 4 | 58 | IRRADIATION BEFORE PASTING DIE-BONDING FILM | - | 19.3 | ⊙ | 9/15 | 60 | ○ | 0.6 |
| COMPARATIVE EXAMPLE 5 | 56 | IRRADIATION BEFORE PASTING DIE-BONDING FILM | - | 19.1 | ⊙ | 4/15 | 27 | ○ | 0.7 |
| COMPARATIVE EXAMPLE 6 | 71 | IRRADIATION BEFORE PASTING DIE-BONDING FILM | - | 50.4 | ⊙ | 5/15 | 33 | ○ | 0.6 |
| COMPARATIVE EXAMPLE 7 | 63 | IRRADIATION BEFORE PASTING DIE-BONDING FILM | - | 17.6 | ⊙ | 5/15 | 33 | ○ | 0.6 |
| COMPARATIVE EXAMPLE 8 | 58 | IRRADIATION BEFORE PASTING DIE-BONDING FILM | - | 20.1 | ⊙ | 4/15 | 27 | ○ | 0.7 |
| COMPARATIVE EXAMPLE 9 | 58 | IRRADIATION BEFORE PASTING DIE-BONDING FILM | - | 16.2 | ⊙ | 3/15 | 20 | ○ | 0.9 |
| COMPARATIVE EXAMPLE 10 | 59 | IRRADIATION BEFORE PASTING DIE-BONDING FILM | - | 21.3 | ⊙ | 14/15 | 93 | ○ | 0.5 |
| COMPARATIVE EXAMPLE 11 | 62 | IRRADIATION BEFORE PASTING DIE-BONDING FILM | - | 26.7 | ⊙ | 3/15 | 20 | ○ | 0.8 |
| COMPARATIVE EXAMPLE 12 | 41 | IRRADIATION BEFORE PASTING DIE-BONDING FILM | - | 19.5 | ⊙ | 11/15 | 73 | ○ | 0.6 |
| COMPARATIVE EXAMPLE 13 | 83 | IRRADIATION BEFORE PASTING DIE-BONDING FILM | - | 19.9 | ⊙ | 4/15 | 27 | ○ | 0.9 |
| COMPARATIVE EXAMPLE 14 | 64 | IRRADIATION BEFORE PASTING DIE-BONDING FILM | - | 120 | ⊙ | 4/15 | 27 | ○ | 0.8 |
| COMPARATIVE EXAMPLE 15 | 58 | IRRADIATION AFTER PASTING DIE-BONDING FILM | 24 | 5.2 | × | 0/15 | 0 | ○ | 1.8 |

The standing time represents the time (hr) until irradiation of an ultraviolet ray after pasting the die-bonding film onto the pressure-sensitive adhesive layer precursor.

## Claims

1. A dicing die-bonding film having a dicing film having a pressure-sensitive adhesive layer (2) on an ultraviolet-ray transmitting base (1) and a die-bonding film (3) provided on the pressure-sensitive adhesive layer (2),
wherein the pressure-sensitive adhesive layer (2) is formed by laminating the die-bonding film (3) onto a pressure-sensitive adhesive layer precursor formed from an acrylic polymer comprising an acrylic ester as a main monomer, a hydroxyl group-containing monomer at a ratio in the range of 10 to 40 mol% with respect to 100 mol% of the acrylic ester, and an isocyanate compound having a radical reactive carbon-carbon double bond within a molecular at a ratio in the range of 70 to 90 mol% with respect to 100 mol% of the hydroxyl group-containing monomer, and then curing by irradiating with ultraviolet radiation from the base side, and
wherein the die-bonding film (3) is formed from an epoxy resin.

2. The dicing die-bonding film according to claim 1,
wherein the cumulative radiation of the ultraviolet ray irradiation is in a range of 30 to 1000 mJ/cm².

3. The dicing die-bonding film according to claim 1 or 2,
wherein the acrylic ester is represented by CH₂=CHCOOR
(wherein R is an alkyl group having 6 to 10 carbon atoms).

4. The dicing die-bonding film according to any of claims 1 to 3,
wherein the hydroxyl group-containing monomer is at least any one selected from a group consisting of 2-hydroxyethyl (meth)acrylate, 2-hydroxypropyl (meth)acrylate, 4-hydroxybutyl (meth)acrylate, 6-hydroxyhexyl (meth)acrylate, 8-hydorxyoctyl (meth)acrylate, 10-hydroxydecyl (meth)acrylate, 12-hydroxylauryl (meth)acrylate, and (4-hydroxymethylcyclohexyl)methyl (meth)acrylate.

5. The dicing die-bonding film according to any of claims 1 to 4,
wherein the isocyanate compound having a radical reactive carbon-carbon double bond is at least one of 2-methacryloyloxyethyl isocyanate and 2-acrylolyloxyethyl isocyanate.

6. The dicing die-bonding film according to any of claims 1 to 5,
wherein the weight average molecular weight of the acrylic polymer is in a range of 350,000 to 1,000,000.

7. The dicing die-bonding film according to any of claims 1 to 6,
wherein the tensile modulus at 23 °C of the pressure-sensitive adhesive layer (2) after ultraviolet ray irradiation is in the range of 7 to 170 MPa.

8. The dicing die-bonding film according to any of claims 1 to 7,
wherein the acrylic polymer comprising the pressure-sensitive adhesive layer (2) does not contain an acrylic acid as a monomer component.

9. A method for manufacturing a dicing die-bonding film having a dicing film having a pressure-sensitive adhesive layer (2) on an ultraviolet-ray transmitting base (1) and a die-bonding film (3) provided on the pressure-sensitive adhesive layer (2),
comprising the following steps:
- a step of forming on the base a pressure-sensitive adhesive layer precursor containing a polymer containing an acrylic ester as a main monomer, a hydroxyl group-containing monomer at a ratio in the range of 10 to 40 mol% with respect to 100 mol% of the acrylic ester, and an isocyanate compound having a radical reactive carbon-carbon double bond within a molecular at a ratio in the range of 70 to 90 mol% with respect to 100 mol% of the hydroxyl group-containing monomer,
- a step of pasting the die-bonding film (3) onto the pressure-sensitive adhesive layer precursor, and
- a step of forming the pressure-sensitive adhesive layer (2) pasted the die-bonding film by irradiating the pressure-sensitive adhesive layer precursor with an ultraviolet radiation from the base side.

10. The method according to claim 8,
wherein the irradiation with the ultraviolet radiation is performed in a range of 30 to 1000 mJ/cm²,

11. A method of manufacturing a semiconductor device using a dicing die-bonding film comprising a dicing film having a pressure-sensitive adhesive layer (2) on a base (1) and a die-bonding film (3) provided on the pressure-sensitive adhesive layer (2),
wherein the dicing die-bonding film (10) according to any of claims 1 to 8 is prepared, and comprising the following steps:
- a step of press-pasting a semiconductor wafer (4) onto the die-bonding film (3'),
- a step of forming a semiconductor chip (5) by dicing the semiconductor wafer (4) together with the die-bonding film (3'), and
- a step of peeling the semiconductor chip (5) together with the die-bonding film (3') off the pressure-sensitive adhesive layer (2), and
- wherein the pressure-sensitive adhesive layer (2) is not irradiated with the ultraviolet ray from the step of press-pasting the semiconductor wafer (4) to the step of peeling off the semiconductor chip (5).
